# EUROPEAN PATENT SPECIFICATION

(11) **EP 1 713 128 B1**
(45) Date of publication and mention of the grant of the patent: **06.07.2011**
(21) Application number: 06007623.9
(22) Date of filing: 11.04.2006
(51) Int. Cl.: H01L 29/08, H01L 29/739

(54) **IGBT and electric power conversion device using it**
IGBT und diesen verwendende elektrische Stromwandlungsvorrichtung
IGBT et appareil de conversion de puissance électrique l'utilisant

(30) Priority: 14.04.2005 JP 2005116406
(43) Date of publication of application: 18.10.2006
(60) Divisional application: 10009398.8
(73) Proprietor: HITACHI, LTD., Chiyoda-ku Tokyo 100-8280 (JP)
(72) Inventor: Arai, Taiga Hitachi, Ltd., Chiyoda-ku Tokyo 100-8220 (JP); Mori, Mutsuhiro Hitachi, Ltd., Chiyoda-ku Tokyo 100-8220 (JP); Oyama, Kazuhiro Hitachi, Ltd., Chiyoda-ku Tokyo 100-8220 (JP); Kohno, Yasuhiko Hitachi, Ltd., Chiyoda-ku Tokyo 100-8220 (JP); Sakurai, Naoki Hitachi, Ltd., Chiyoda-ku Tokyo 100-8220 (JP)
(74) Representative: Strehl Schübel-Hopf & Partner

(56) References cited:
- EP-A- 0 718 892
- EP-A- 0 837 508
- US-B1- 6 271 061
- US-B1- 6 384 431

## Description

### BACKGROUND OF THE INVENTION

### Field of the invention

This invention relates to an insulated gate bipolar transistor causing less occurrence of noises and having lower loss.

### Description of the related art

An insulated gate bipolar transistor (hereinafter, IGBT) is a switching element that controls current flowing between a collector electrode and an emitter electrode by the voltage applied to a gate electrode. Its controllable electric power ranges from tens of watts to hundreds of thousands of watts, and its switching frequency is also as wide as from tens of hertz to over hundreds of kilohertz. Utilizing these characteristics, it is widely used from low power equipment such as an air conditioner, a microwave oven to large power equipment such as a railroad, an inverter for ironworks.

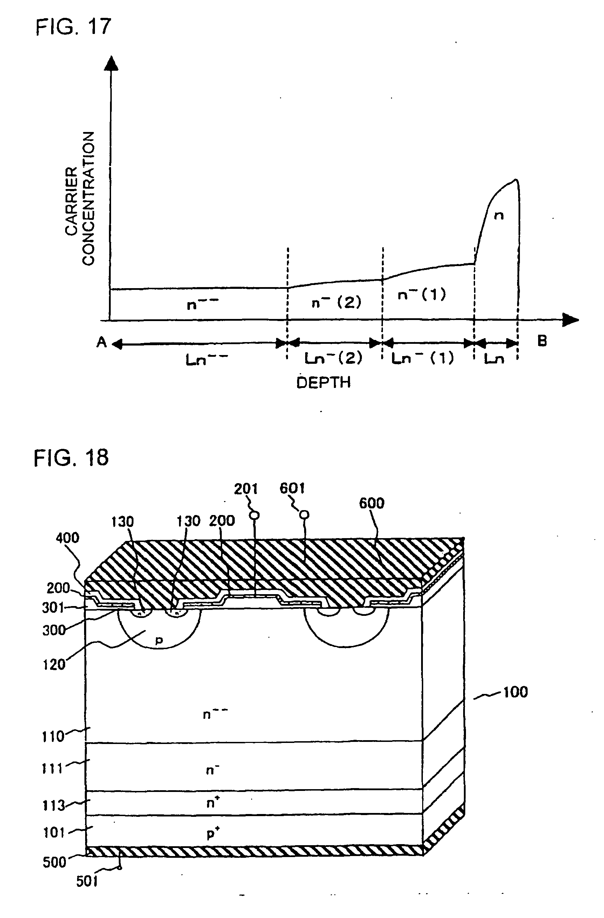

Fig. 18 shows an IGBT which restrains bouncing voltage at turning off and enlarges a reverse bias safety operation area (hereinafter, RBSOA), as described in Patent Document 1. In Fig. 18, the reference number 500 is a collector electrode; 101 is a p⁺-layer contacting the collector electrode 500 with a low resistance; 113 is an n⁺-layer having a lower carrier concentration than the p⁺-layer 101; 111 is an n⁻-layer having a lower carrier concentration than the n⁺-layer 113; 110 is an n^{- -}-layer having a lower carrier concentration than the n⁻-layer 111; 120 is a p-layer; 130 is an n⁺-layer; 600 is an emitter electrode contacting the n⁺-layer 130 with a low resistance; 300, 301 and 400 are dielectric layers; 501 is a collector terminal; 601 is an emitter terminal; 200 is a gate electrode; and 201 is a gate terminal.

The characteristic of the IGBT shown in Fig. 18 is that it has a structure with the n⁻-layer 111 being added between the n⁺-layer 113 and the n^{- -}-layer 110. When breaking current of the IGBT, or turning it off, a depleted layer extends from the boundary between the p-layer 120 and the n^{- -}-layer 110 to the n^{- -}-layer 110 side. When the depleted layer reaches the n⁺-layer 113 having a higher impurity concentration, the residual carrier rapidly diminishes and the current quickly decreases. As the current quickly decreases, a high bouncing voltage Vsp = Ls x di/dt is applied to both ends of the IGBT due to its current change rate di/dt and its parasitic inductance Ls existing in the circuit, and the loss increases. Accordingly, the n⁻-layer 111 is provided to the IGBT shown in Fig. 18 for easing extension of the depleted layer and for preventing the voltage rebound phenomena due to a rapid decrease of current.

### [Patent Document 1]

Japanese Unexamined Patent Application Publication No. 10-189956 (Fig. 1; Description from the paragraph (008) to the paragraph (0010))

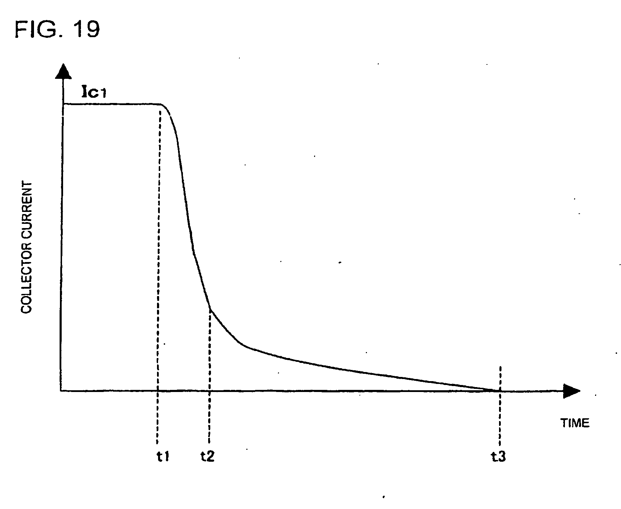

However, the IGBT shown above in Fig. 18 has the following problems. Fig. 19 shows a main current wave form at turning off of the IGBT shown in Fig. 18. The collector current having flown at largeness of Ic1 begins decreasing when turning off of the IGBT at the time of t1. However, decreasing of current becomes less sharply at the time of t2, and the current decreases like trailing slowly till the time of t3. The current during the time period between the times of t2 and t3 is called tail current.

The tail current is mainly due to a residual carrier, and the largeness of the current is determined by the residual region of carrier, or the carrier lifetime of the n⁻-layer 111 region shown in Fig. 18. In order to decrease the current, there is a method to increase the carrier concentration of the IGBT n⁻-layer shown in Fig. 18 and to shorten the lifetime, however, as described in the paragraph (0020) of Patent Document 1, the bouncing voltage cannot be restrained at turning off and the RBSOA becomes narrower as the carrier concentration of the n⁻-layer 111 is larger. In addition, the blocking voltage decreases as the electric field at a pn junction on the emitter side.

The patent US 6,384,431 describes an insulated gate bipolar transistor comprising an n-type intermediate region.

### SUMMARY OF THE INVENTION

The object of the present invention is to solve the above-mentioned problems and to provide a reliable semiconductor device with a low loss and an electric power conversion device using it.

The object of the invention is attained by a semiconductor device according to claim 1. Further developments are specified in the dependent claims.

According to the present invention, since the turnoff loss of an IGBT can be reduced without reducing the reverse bias safety operation area (RBSOA), the efficiency of an electric power conversion device can be improved.

### BRIEF DESCRIPTION OF THE DRAWINGS

Fig. 1 is a sectional structure view of IGBT in Embodiment 1;
Fig. 2 is a carrier concentration profile view between A-B in Fig. 1;
Fig. 3 is an explanation drawing of current wave form when turning off IGBT in Embodiment 1;
Fig. 4 is a sectional structure view of IGBT in Embodiment 2;
Fig. 5 is a sectional structure view of IGBT in Embodiment 3;
Fig. 6 is a sectional structure view of IGBT in Embodiment 4;
Fig. 7 is a sectional structure view of IGBT in Embodiment 5;
Fig. 8 is a sectional structure view of IGBT in Embodiment 6;
Fig. 9 is a sectional structure view of IGBT in Embodiment 7;
Fig. 10 is a sectional structure view of IGBT in Embodiment 8;
Fig. 11 is a circuit structure view of electric power conversion device in Embodiment 9;
Fig. 12 is a sectional structure view of diode used in electric power conversion device in Embodiment 9;
Fig. 13 is a sectional structure view of another diode used in electric power conversion device in Embodiment 9;
Fig. 14 is an explanation view of semiconductor substrate on which IGBT, diode used in electric power conversion device in Embodiment 9 is fabricated;
Fig. 15 is a carrier concentration profile view between A-B in Fig. 14;
Fig. 16 is an another carrier concentration profile view between A-B in Fig. 14;
Fig. 17 is a further carrier concentration profile view between A-B in Fig. 14;
Fig. 18 is a sectional structure view of IGBT in conventional technique;
Fig. 19 is an explanation drawing of current wave form when turning off IGBT in conventional technique.

### DETAILED DESCRIPTION OF THE PREFERRED EMBODIMENTS

In the following, the details of the present invention are described referring to drawings.

### [Embodiment 1]

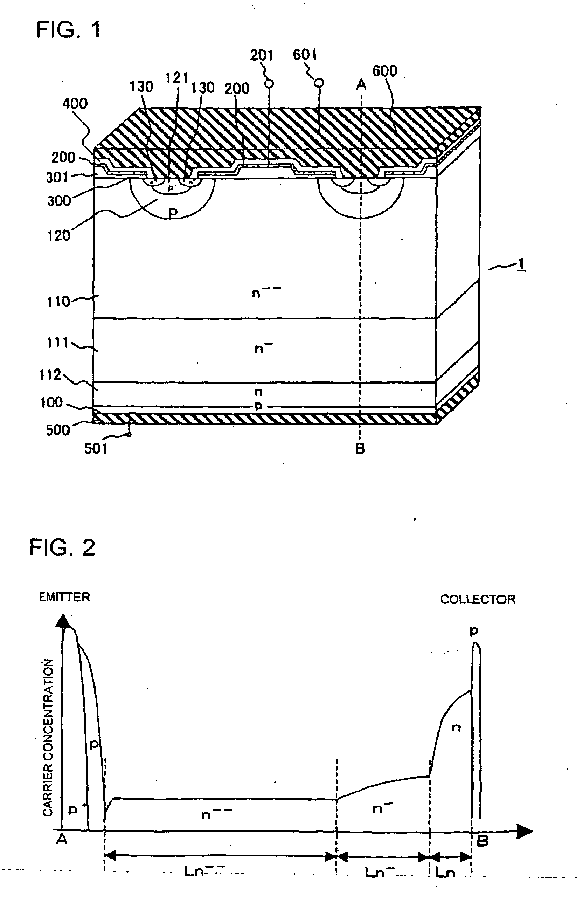

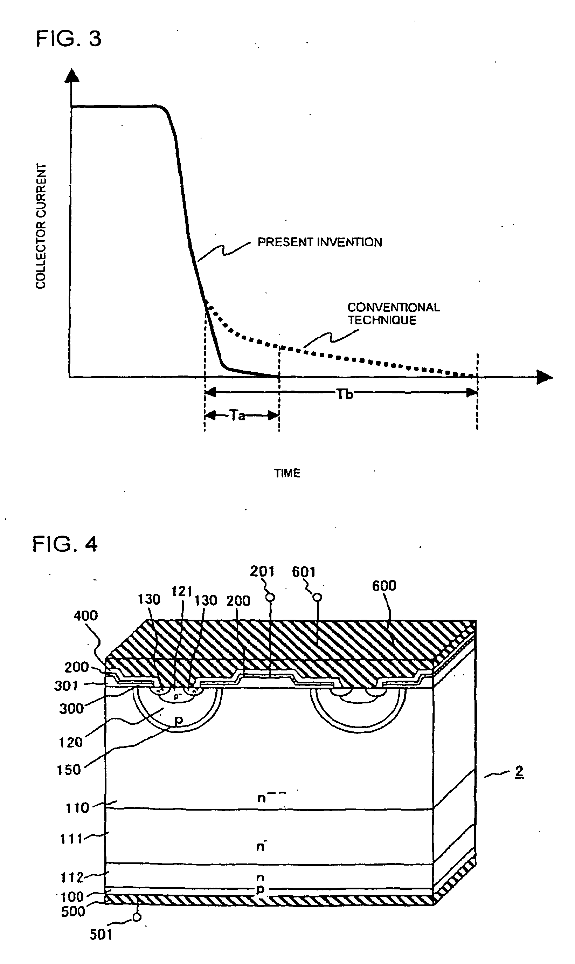

Fig. 1 shows a sectional structure view of an IGBT of the present embodiment. In Fig. 1, the same reference numerals are provided to the same components as in Fig. 18. Fig. 2 shows a concentration profile between A-B shown in Fig. 1, and Fig. 3 shows an example of a turnoff wave form of the IGBT shown in Fig. 1. In Fig. 1, the reference numeral 112 indicates an n-layer with a low carrier concentration, and 100 indicates a p-layer with a low carrier concentration.

The characteristic of the IGBT shown in Fig. 1 is that the carrier concentrations of the p-layer 100 and the n-layer 112 are lower than that of an IGBT of said prior art and has an n⁻-layer 111. If the carrier concentration of the p-layer 100 is low, injection of holes from the p-layer 100 would be restrained and the carrier concentrations of the n-layer 112 and the n⁻-layer 111 would be lower. If the carrier concentration of the n⁻-layer 111 is lower, the residual carrier inside the n⁻-layer 111 at turning off would be smaller and the tail current would be reduced. Thereby, the current wave form at turning off would be one as shown in solid lines in Fig. 3, and the tail period Ta would be shorter than the tail period Tb of an IGBT of prior art shown in dotted lines and thus the loss can be reduced. Since in the present embodiment, there is a long-life n-layer 111, rapid decrease of the tail current can be restrained and a turnoff property not causing bouncing voltage can be realized.

In order to realize a high reliability, a high blocking voltage and a low loss at the same time in the IGBT of the present embodiment, the carrier concentration of the p-layer 100 is in the range of 10-100 times of the carrier concentration of the n-layer 112 and particularly, the sum (sheet carrier concentration) of the carrier concentration of the n-layer 112 is of 1 x 10¹²cm⁻² to 1 x 10¹³cm⁻² and the thickness of the p-layer 100 to be 3 µm or less. The reason is described below.

When the carrier concentration of the p-layer 100 is below 10 times of the carrier concentration of the n-layer, carrier injection from the p-layer 100 would be reduced. In such a case, since the carrier concentration inside the n-layer 111 would be also reduced, as a depleted layer extending from the junction between the p-layer 120 and the n^{- -}-layer 110 into the n^{- -}-layer 110 reaches the n⁻-layer 111 at turning off, the current rapidly decreases and a bouncing voltage is generated. When the carrier concentration of the p-layer 100 is 100 times of the carrier concentration of the n-layer 112 or more, carrier injection from the p-layer would be excessively larger, increasing the tail current and a loss increases. Accordingly, it is preferable to set the relation of the carrier concentration between the p-layer 100 and the n-layer 112 to be in the range of 10-100 times.

Next, when the carrier concentration of the n-layer 112 is below 10¹²cm⁻², overvoltage is applied to the IGBT and when the depleted layer reaches the n-layer 112, extension of the depleted layer to the p-layer 100 cannot be restrained and the depleted layer reaches the p-layer 100, causing a punch through phenomena. When the punch through phenomena is caused, the current begins to flow preventing the IGBT from functioning as a switch. On the other hand, when the carrier concentration of the n-layer 112 is higher than 1 x 10¹³cm⁻², the carrier concentration of the p-layer should be higher than 1 x 10¹⁴cm⁻², causing various problems related to manufacturing. For example, when a p-layer 100 with the carrier concentration of 1 x 10¹⁴cm⁻² or more is formed by the impurity implantation method with boron or the like, since ion implantation quantity would be excessively large, the crystalline failure of a silicon semiconductor substrate would be increased, causing a larger leak current. Thus, the inventors demonstrated through experiences that the carrier concentration of the n-layer 112 had a preferable range.

If the thickness of the p-layer 100 is 3 µm or less, carrier injection from the p-layer 100 can be reduced without reducing the carrier concentration and the leak current can be reduced by reducing the above mentioned impurity implantation quantity. Where, it is preferable that the thickness of the p-layer 100 is 3 µm - 0.3 µm, and more preferably, 3 µm - 1 µm. If the thickness of the p-layer is below 0.3 µm, the electric contact with the collector electrode 500 might be a failure.

In addition, since the p-layer 100 contacting the collector electrode 500 has a lower surface carrier concentration, the contact resistance would be larger according to the kind of metal to be used for the collector electrode 500. Thus, by applying p-type impurity, for example aluminum or an alloy including aluminum to the collector electrode, it was found that the contact resistance with the p-layer 100 could be reduced. As a result of the experiments by the inventors, it was found that by using aluminum as part of the collector electrode 500, the electric contact with the low-concentration p-layer 100 had no problem and that the loss reduction of a semiconductor device and the short-circuit resistance could be secured.

Furthermore, by considering the blocking voltage improvement of an IGBT with the structure shown in Fig. 1, the following points were also found out. When the thickness of the n^{- -}-layer 110 is Ln^{- -}, the thickness of the n⁻-layer 111 is Ln⁻, and the thickness of the n-layer 112 is Ln, by setting as Ln^{- -} > Ln⁻ > Ln, the electric field strength of the boundary between the n^{- -}-layer 110 and the p-layer 120 is reduced, and the blocking voltage increases. It is known that especially in a semiconductor having a blocking voltage of 5kV-6kV or higher, the destruction frequency due to cosmic rays increases while it was found that the IGBT of the present embodiment had improved cosmic ray tolerance. It was confirmed that by setting Ln^{- -} > Ln⁻ > Ln, the blocking voltage increased even when the carrier concentration of the p-layer or the n-layer 112 was high.

It is also possible that the blocking voltage is low and for an IGBT requiring no consideration of the cosmic ray tolerance, the continuity loss can be reduced by making thicker the thickness Ln⁻ of the n⁻-layer 111 and making thinner the entire silicon substrate between the collector and the emitter.

### [Embodiment 2]

Fig. 4 shows an IGBT sectional structure view of the present embodiment. In Fig. 4, the same reference numerals are provided to the same components as in Fig. 1. The structure shown in Fig. 4 is different from Fig. 1 of Embodiment 1 with regard to having the n-layer 150 with a higher concentration than that of the n^{- -}-layer 110 while the others are identical. A positive carrier injected from the p-layer 100, or a hole flows into an emitter electrode 600 through the n-layer 112, the n⁻-layer 111, the n^{- -}-layer 110, the p-layer 120 and the p⁺-layer 121. When the n-layer 150 is formed, since the n-layer 150 has a higher potential barrier than the n^{- -}-layer 110 for a hole, the holes do not easily flow into the p-layer 120 and accumulated in the n-layer 110. As the holes are accumulated in the n^{- -}-layer 110, the resistance in conducting state decreases and thus the conduction loss can be reduced.

Though in the lowly injected p-layer 100, injection of holes decreases and thus the carrier accumulated in the n-layer 110 decreases and the conduction loss might be larger, according to the present embodiment, the conduction loss does not increase since the holes are accumulated in the n-layer 110 by the n-layer 150 even if injection of the p-layer 100 is reduced.

### [Embodiment 3]

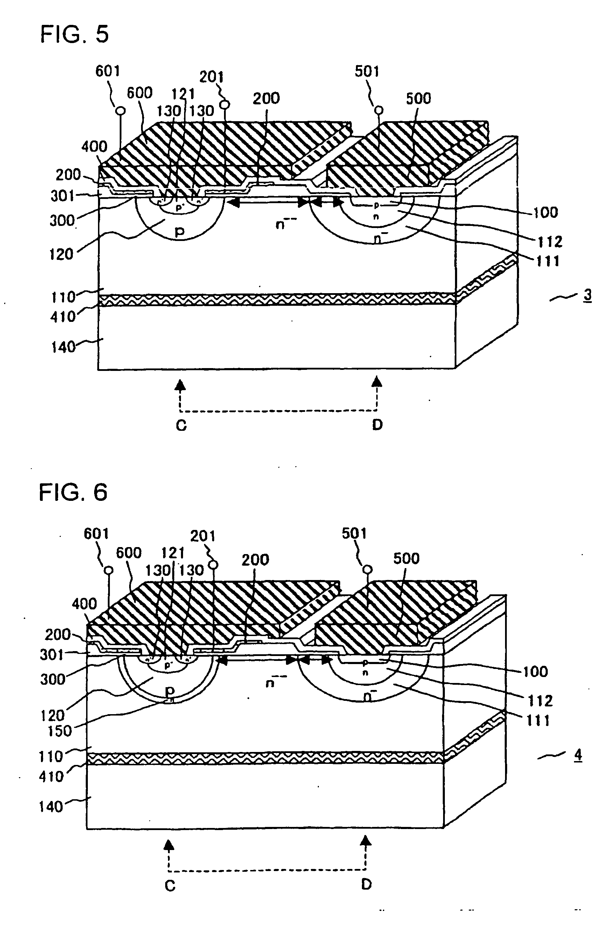

Fig. 5 shows a sectional structure view of an IGBT of the present embodiment. In Fig. 5, the same reference numerals are provided to the same components as in Figs. 1 and 4. In Fig. 5, the reference numeral 410 indicates a dielectric film and 140 indicates a semiconductor substrate. The characteristic of Fig. 5 is to be an IGBT on which a collector electrode 500 and an emitter electrode 600 are formed on the same surface, or of a lateral type. The n-layer 110 is electrically isolated by the semiconductor substrate 140 and the dielectric layer 410. Since in such a structure, all the electrodes are arranged on the same surface and protection circuits and drive circuits can be integrated in the same chip, such a structure is favorable for a high voltage LSI and the like. In the present embodiment, similarly to Embodiment 1 and Embodiment 2, the turnoff loss is reduced by the p-layer 100, the n-layer 112 and the n⁻-layer 111 with low concentration. It would also be possible to provide blocking voltage improvement effect which is called RESURF effect by making the semiconductor substrate 140 to have the same potential as the emitter electrode. Though the RESURF effect could cause electric field concentration just below the p-layer 120, the blocking voltage can be further improved by making the potential optional among the potential of the collector electrode and that of the emitter electrode.

### [Embodiment 4]

Fig. 6 shows an IGBT sectional structure view of the present embodiment. In Fig. 6, the same reference numerals are provided to the same components as in Figs. 1, 4 and 5. In the present embodiment, in addition to the structure shown in Embodiment 3, an n-layer 150 having a higher concentration than the n^{- -}-layer 110 shown in Fig. 6 is arranged. In the present embodiment shown in Fig. 6, similarly to Embodiment 2, since carriers are accumulated in the n^{- -}-layer 110 by the n-layer 150, the conduction loss can be reduced. It would also be possible to provide blocking voltage improvement effect which is called RESURF effect by making the semiconductor substrate 140 to have the same potential as the emitter electrode. Though the RESURF effect could cause electric field concentration just below the p-layer 120, the blocking voltage can be further improved by making the potential optional among the potential of the collector electrode and that of the emitter electrode.

### [Embodiment 5]

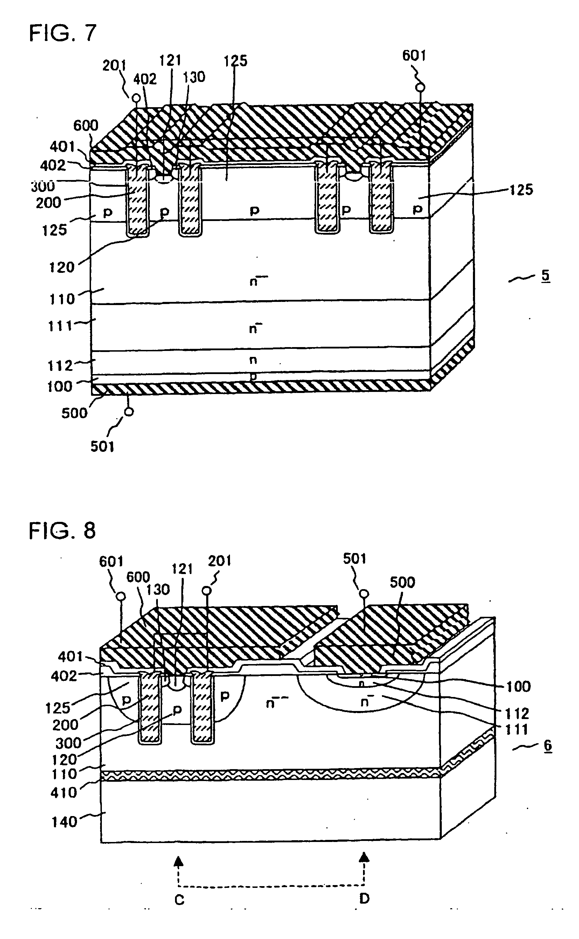

Fig. 7 shows a sectional structure view of an IGBT of the present embodiment. In Fig. 7, the same reference numerals are provided to the same components as in Fig. 1. In Fig. 7, the reference numeral 125 indicates a p-layer, and 401 and 402 indicate dielectric layers. In the present embodiment, a low concentration p-layer 100, an n-layer 112 and an n⁻-layer 111 are provided to a trench gate type IGBT. In Fig. 7, an emitter electrode 600 electrically contacts the p+-layer 121 and the n⁺-layer 130 in a region with a short distance between adjacent trench type MOS gates (a gate electrode 200, a gate dielectric film 300). In this section, the p-layer 125 at a part with a wide interval between the adjacent trench gate type gates is insulated and separated from the emitter electrode 600 by the dielectric films 401, 402, and the p-layer 125 has a floating potential. As a result, part of the holes injected from the p-layer 100 temporarily flows into the p-layer 125, flows along the bottom of the trench type MOS gate and flows into the emitter electrode 600. As a result, these holes function like a base current of a bipolar transistor and electrons are injected into the n^{- -}-layer 110 from the accumulation layer formed on the bottom of the trench type MOS gate, enhancing conductivity modulation of the n^{- -}-layer 110. Thereby, the IGBT of the present embodiment has a low loss.

In the present embodiment, similarly to Embodiment 2, even when carrier injection in the low concentration p-layer 100 decreases and conduction loss increases, increase of conduction loss can be avoided by enhancement of the above-mentioned conductivity modulation.

### [Embodiment 6]

Fig. 8 shows a sectional structure view of an IGBT of the present embodiment. In Fig. 8, the same reference numerals are provided to the same components as in Figs. 5 and 7. An IGBT of the present embodiment is a so-called lateral type semiconductor 6 on which a collector electrode 500 and an emitter electrode 600 are formed on the same surface, facilitating application of the trench gate type structure shown in Embodiment 5 for a high voltage LSI. A floating p-layer 125 is formed on the region facing the collector side, realizing the improvement effect of conductivity modulation described in Embodiment 5 and allowing high integration of a high voltage LSI. In the present embodiment, by providing a p-layer 125, the electric field applied to a gate dielectric film 300, especially the electric field on the collector side can be eased, thus heightening reliability of the gate dielectric film 300.

### [Embodiment 7]

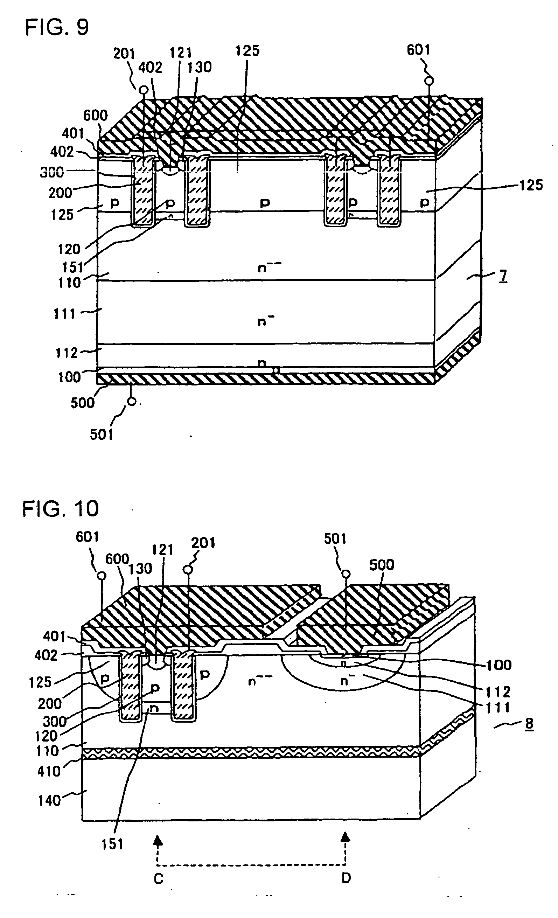

Fig. 9 shows a sectional structure view of an IGBT of the present embodiment. In Fig. 9, the same reference numerals are provided to the same components as in Fig. 7 of Embodiment 5. The IGBT of the present embodiment is different from the IGBT of the Embodiment 5 shown in Fig. 7 in respect to addition of an n-layer 151 and the others are identical. The n-layer 151 provided between the p-layer 120 and the n^{- -}-layer 110 of the region with a short distance between adjoining trench type MOS gates has similar effects as the n-layer 150 of Embodiment 2, accumulates holes in the n^{- -}-layer 110 and reduces further conduction loss.

### [Embodiment 8]

Fig. 10 shows a sectional structure view of an IGBT of the present embodiment. In Fig. 10, the same reference numerals are provided to the same components as in Fig. 8 of Embodiment 6. In the present embodiment, the IGBT is different from that of the Embodiment 6 shown in Fig. 8 in respect to addition of an n-layer 151 and the others are identical. The n-layer 151 provided between the p-layer 120 and the n^{- -}-layer 110 of the region with a short distance between adjoining trench type MOS gates has similar effects as the n-layer 150 of Embodiment 2, accumulates holes in the n^{- -}-layer 110 and reduces further conduction loss.

### [Embodiment 9]

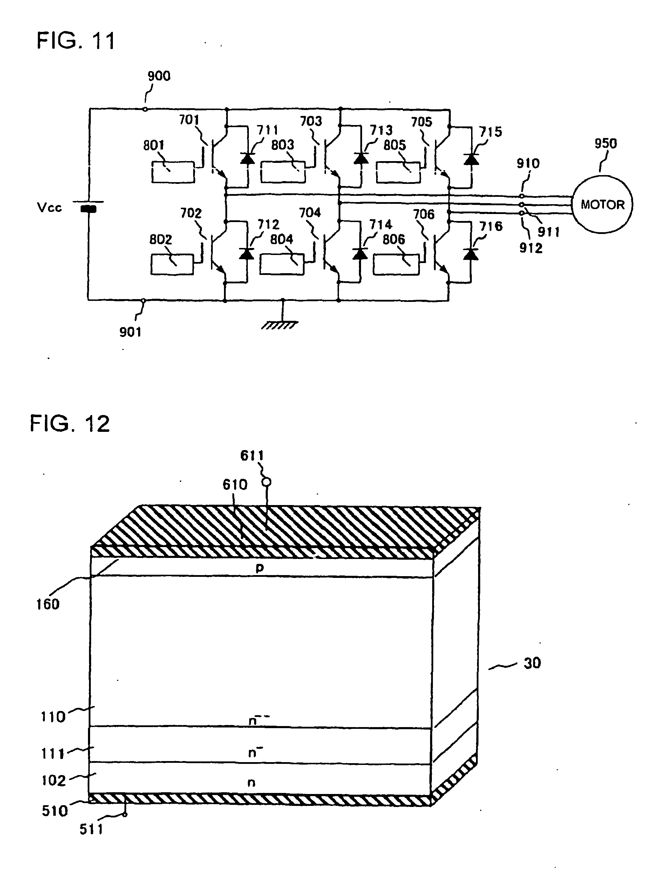

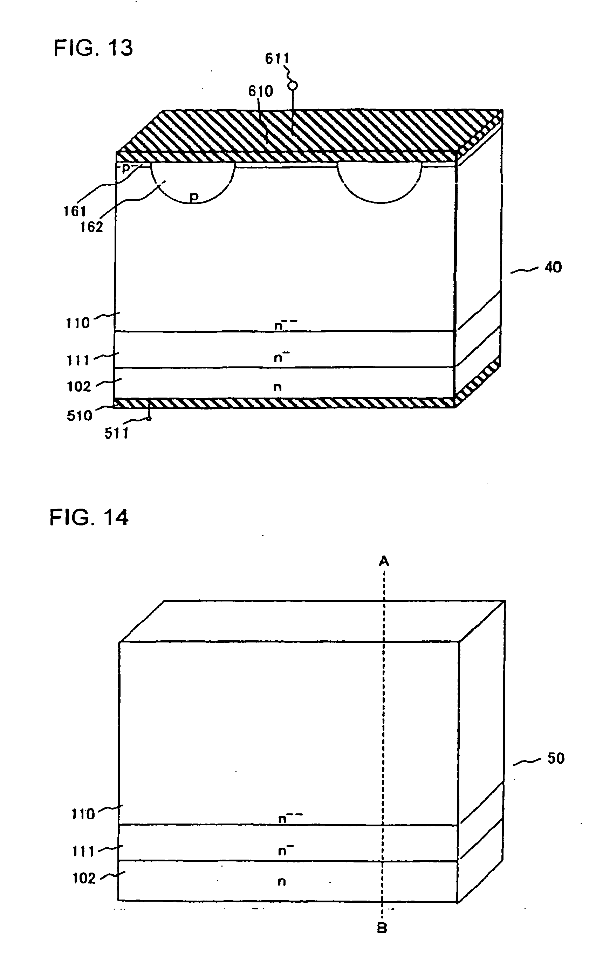

Fig. 11 shows a circuit structure of the inverter part of an electric power conversion device of the present embodiment. Figs. 12 and 13 show a sectional structure view of a diode used for the electric power conversion device of the present embodiment. In the electric power conversion device shown in Fig. 11, IGBT's with the structures described from Embodiments 1-8 are used for IGBT's 701-706 as electric power semiconductor switching elements, and the diodes with the structures shown in Figs. 12, 13 are applied to diodes 711-716. An IGBT chip and a diode chip are loaded on a ceramics circuit substrate arranged on a metal base as a so-called IGBT module and contained in a resin case or resin-molded.

In Fig. 11, the reference numerals 801-806 indicate gate circuits, 900 indicates a P terminal and 901 indicates an N terminal, to which a direct current power source is connected. In Fig. 11, the reference numeral 910 indicates a U terminal, 911 indicates a V terminal and 912 indicates a W terminal. In the present embodiment, as shown in Fig. 11, two IBGT's comprise three serially connected arms, the connection points of an upper arm and an under arm of each arm are respectively connected to the U terminal 910, the V terminal 911 and the W terminal 912, and a three-phase alternating current electric power is output to a motor 950 as a load from these three terminals.

Fig. 12 is a sectional view of a reflux diode connected in inverse-parallel to an IGBT of an electric power conversion device of the present embodiment, where the reference numeral 510 indicates a cathode electrode, 102 indicates an n-layer, 111 indicates an n⁻-layer having a lower concentration than the n-layer 102, 110 indicates an n^{- -}-layer having a lower concentration than the n⁻-layer 111, 160 indicates a p-layer, 610 indicates an anode electrode contacting the p-layer 160 with a low resistance, 511 indicates a cathode terminal and 611 indicates an anode terminal.

Fig. 13 is a sectional structure of a diode having a low injection anode structure, and the same reference numerals are provided to the same components as in Fig. 12. In Fig. 13, the reference numeral 162 indicates the p-layer and 161 indicates a low concentration p⁻-layer which has shottokey contacted with the anode electrode 610.

The diodes in Figs. 12, 13 have a structure to prevent by the n⁻-layer 111 reaching of the depleted layer extending from a pn junction on the anode side to the n^{- -}-layer 110 to the n-layer 102 at the time of transient from the energized state to the application state of a reverse direction voltage, or a reverse recovery. Thereby, current vibration generated at the reverse recovery and overvoltage generated in accordance with it are prevented.

The electric power conversion device shown in Fig. 11 realizes a low loss and high reliability at the inverter part by using the diodes shown in Fig. 12 or 13 together with the IGBT's of the Embodiments 1-8. In Fig. 11, when applying only the switching element according to the present invention, it is possible to apply the structure according to the present invention, for example only for its IGBT, however, since a diode might cause current vibration or voltage bouncing at the reverse recovery and the turn-on speed of the IGBT should be moderate, preventing fully demonstrating the performance of the inventive IGBT. In order to demonstrate the performance of the inventive IGBT to the maximum, it would be preferable to combine it to the diode shown in Fig. 12 or 13. The structure of the inverter device shown in Fig. 11 is an example, and it is similarly an example if the serial assembling of upper and lower arms to which a switching element and a diode are in reverse parallel presents an inverter device which is connected with the same number of phases as the alternating current output.

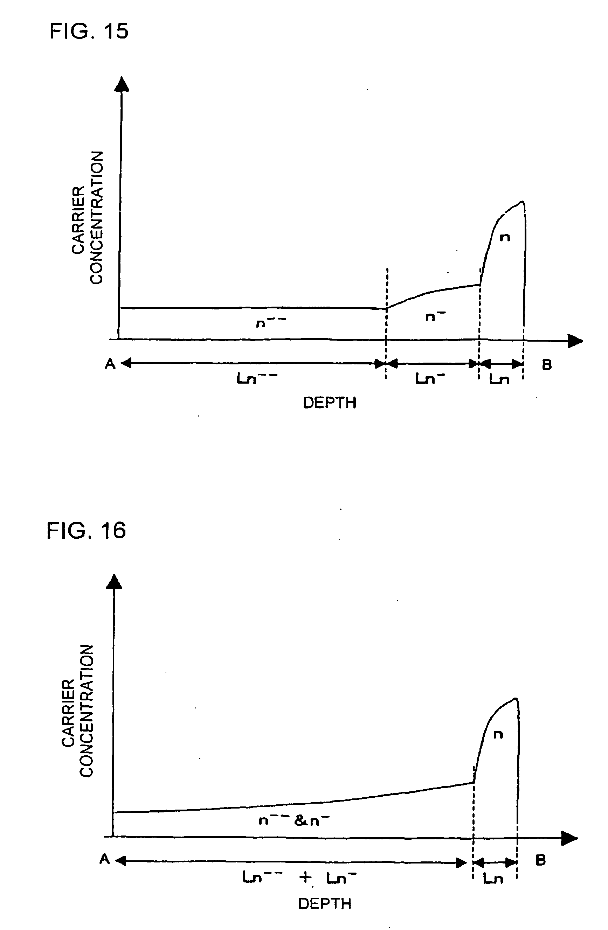

The switching element and the diode constituting the electric power conversion device of the present embodiment shown in Fig. 11 can be fabricated from a semiconductor substrate with the same structure as shown in Fig. 14, for example a silicon substrate. In Fig. 14, the reference numeral 102 indicates an n-layer, 111 indicates an n⁻-layer having a lower concentration than the n-layer 102, and 110 indicates an n^{- -}-layer having a lower concentration than the n⁻-layer 111. Fig. 15 indicates a concentration distribution between A-B in Fig. 14.

The semiconductor substrate shown in Fig. 14 may be a substrate having a carrier concentration distribution as shown in Figs. 16 and 17 in addition to the carrier concentration distribution shown in Fig. 15. The characteristic of the semiconductor substrate shown in Fig. 16 is that the carrier concentration moderately increases from A to B though there is no clear boundary between the n^{- -}-layer 110 and the n⁻-layer 111.

In the semiconductor substrate shown in Fig. 17, the characteristic is that the carrier concentration increases through a plurality of layers from A to B, and in this case, through two n⁻-layers with different concentrations. Fabrication of these substrates shown in Figs. 16 and 17 can be performed by applying ion plantation, epitaxial growth or thermal diffusion and the formation can be performed from either the n^{- -}-layer 110 side or the n-layer 102 side. Since the n-layer 102 has a thinner thickness than those of the n^{- -}-layer 110 and the n⁻-layer 111, it can be formed during any step in the manufacturing process.

When combining and using an IGBT and a diode, for example using as a power module, the entire reliability decreases if the property such as blocking voltage, cosmic ray tolerance is low. The inventors confirmed that a diode can obtain a high blocking voltage and high cosmic ray tolerance effects as similar as an IGBT when the n^{- -}-layer thickness Ln^{- -}, n⁻-layer thickness Ln⁻ and the n-layer thickness Ln in Fig. 15 satisfy the largeness relation of Ln^{- -} > Ln⁻ > Ln. It is preferable that for further low loss of the diode, the sheet carrier concentration of the n-layer concentration be 1 x 10¹² cm⁻² or less or the peak concentration is 1 x 10¹⁶ cm⁻³ or less, or satisfies both. Thereby, carrier injection from the cathode is restrained and the loss at turning off of a diode is reduced.

As described above, in the present embodiment, though an inverter for converting direct current into alternating current was described, it should not be limited in this and a converter for converting alternating current into direct current could be as similar as this.

## Claims

1. A semiconductor device, comprising:
a first semiconductor region (100) of a first conducting type adjoining a main surface of a semiconductor substrate;
a second semiconductor region (112) of a second conducting type adjoining said first semiconductor region (100) and having a lower carrier concentration than the first semiconductor region (100);
a third semiconductor region (111) of the second conducting type adjoining said second semiconductor region (112) and having a lower carrier concentration than the second semiconductor region (112);
a fourth semiconductor region (110) of the second conducting type adjoining said third semiconductor region (111) and having a lower carrier concentration than the third semiconductor region (111);
a fifth semiconductor region (120) of the first conducting type extending from a main surface of said semiconductor substrate into said fourth semiconductor region (110);
a sixth semiconductor region (130) of the second conducting type extending from a main surface of said semiconductor substrate into the corresponding fifth semiconductor region (120);
a dielectric film (300) formed on an exposed part of the main surface of the fifth semiconductor region (120) between said fourth and sixth semiconductor regions (110, 130);
a first electrode (200) formed on the corresponding dielectric film (300);
a second electrode (600) contacting said fifth and sixth semiconductor regions (120, 130); and
a third electrode (500) contacting said first semiconductor region (100);
wherein the maximum carrier concentration of said first semiconductor region (100) is 10 to 100 times the maximum carrier concentration of said second semiconductor region (112),
**characterised in that** the carrier concentration of said second semiconductor region (112) is 1 x 10¹² cm⁻² to 1 x 10¹³ cm⁻².

2. The semiconductor device according to Claim 1, wherein said fifth semiconductor region (120) extends into said fourth semiconductor region (110) from a main surface of said substrate other than that adjoined by said first semiconductor region (100). (Fig. 1)

3. The semiconductor device according to Claim 2, wherein the thickness of said second semiconductor region (112) is smaller than that of said third semiconductor region (111) and the thickness of said third semiconductor region (111) is smaller than that of said fourth semiconductor region (110).

4. The semiconductor device according to Claim 1,
wherein said fifth semiconductor region (120) extends into said fourth semiconductor region (110) from that main surface of said substrate which is adjoined by said first semiconductor region (100); and
wherein said third electrode (500) is arranged on the same main surface of said substrate as, and spaced from, said second electrode (600). (Fig. 4)

5. The semiconductor device according to Claim 2 or 4, wherein the semiconductor device has a seventh semiconductor region (150) of the second conducting type arranged between said fourth and fifth semiconductor regions (110, 120), adjoining said fifth semiconductor region (120) and having a higher carrier concentration than said fourth semiconductor region (110). (Fig. 6)

6. The semiconductor device according to Claim 2 or 4, wherein the thickness of said first semiconductor region (100) is 3 µm or less.

7. The semiconductor device according to Claim 2 or 4, wherein the surface of said third electrode (500) contacting said first semiconductor region (100) contains aluminum.

8. The semiconductor device according to Claim 2, wherein:
said first electrode includes a plurality of MOS type trench gate electrodes (200) having at least two kinds of different intervals and extending from a main surface of said substrate into said fourth semiconductor region (110); and
the semiconductor device has a seventh semiconductor region (151) of the second conducting type being between said trench gate electrodes (200), positioned between said fourth and fifth semiconductor regions (110, 120), contacting said trench gate electrodes (200) and having a higher carrier concentration than said fourth semiconductor region (110). (Fig. 10)

## Patentansprüche

1. Halbleitervorrichtung mit
einem an eine Hauptfläche eines Halbleitersubstrats angrenzenden ersten Halbleiterbereich (100) eines ersten Leitungstyps,
einem an den ersten Halbleiterbereich (100) angrenzenden zweiten Halbleiterbereich (112) eines zweiten Leitungstyps, der eine niedrigere Ladungsträgerkonzentration hat als der erste Halbleiterbereich (100),
einem an den zweiten Halbleiterbereich (112) angrenzenden dritten Halbleiterbereich (111) des zweiten Leitungstyps, der eine geringere Ladungsträgerkonzentration hat als der zweite Halbleiterbereich (112),
einem an den dritten Halbleiterbereich (111) angrenzenden vierten Halbleiterbereich (110) des zweiten Leitungstyps, der eine geringere Ladungsträgerkonzentration hat als der dritte Halbleiterbereich (111),
einem von der Hauptfläche des Halbleitersubstrats aus in den vierten Halbleiterbereich (110) verlaufenden fünften Halbleiterbereich (120) des ersten Leitungstyps,
einem von der Hauptfläche des Halbleitersubstrats in den entsprechenden fünften Halbleiterbereich (120) verlaufenden sechsten Halbleiterbereich (130) des zweiten Leitungstyps,
einem auf einem freiliegenden Teil der Hauptfläche des fünften Halbleiterbereichs (120) zwischen dem vierten und dem sechsten Halbleiterbereich (110, 130) ausgebildeten dielektrischen Film (300),
einer auf dem entsprechenden dielektrischen Film (300) ausgebildeten ersten Elektrode (200),
einer den fünften und den sechsten Halbleiterbereich (120, 130) kontaktierenden zweiten Elektrode (600) und
einer den ersten Halbleiterbereich (100) kontaktierenden dritten Elektrode (500),
wobei die maximale Ladungsträgerkonzentration des ersten Halbleiterbereichs (100) das 10- bis 100-Fache der maximalen Ladungsträgerkonzentration des zweiten Halbleiterbereichs (112) beträgt,
**dadurch gekennzeichnet, daß** die Ladungsträgerkonzentration des zweiten Halbleiterbereichs (100) 1 x 10¹² cm⁻² bis 1 x 10¹³ cm⁻² beträgt.

2. Halbleitervorrichtung nach Anspruch 1, wobei der fünfte Halbleiterbereich (120) ausgehend von einer Hauptfläche des Substrats, die von der dem ersten Halbleiterbereich (100) benachbarten Hauptfläche verschieden ist, in den vierten Halbleiterbereich (110) verläuft. (Figur 1)

3. Halbleitervorrichtung nach Anspruch 2, wobei die Dicke des zweiten Halbleiterbereichs (112) geringer ist als die des dritten Halbleiterbereichs (111) und die Dicke des dritten Halbleiterbereichs (1111) geringer ist als die des vierten Halbleiterbereichs (110).

4. Halbleitervorrichtung nach Anspruch 1,
wobei der fünfte Halbleiterbereich (120) von der dem ersten Halbleiterbereich (100) benachbarten Hauptfläche des Substrats aus in den vierten Halbleiterbereich (110) verläuft; und
wobei die dritte Elektrode (500) auf der gleichen Hauptfläche des Substrats wie die zweite Elektrode (600) und in Abstand von dieser angeordnet ist. (Figur 4)

5. Halbleitervorrichtung nach Anspruch 2 oder 4, wobei die Halbleitervorrichtung einen zwischen dem vierten und dem fünften Halbleiterbereich (110, 120) angeordneten siebten Halbleiterbereich (150) des zweiten Leitungstyps aufweist, der an den fünften Halbleiterbereich (120) angrenzt und eine höhere Ladungsträgerkonzentration hat als der vierte Halbleiterbereich (110). (Figur 6)

6. Halbleitervorrichtung nach Anspruch 2 oder 4, wobei die Dicke des ersten Halbleiterbereichs (100) 3 µm oder weniger beträgt.

7. Halbleitervorrichtung nach Anspruch 2 oder 4, wobei die den ersten Halbleiterbereich (100) kontaktierende Fläche der dritten Elektrode (500) Aluminium enthält.

8. Halbleitervorrichtung nach Anspruch 2, wobei
die erste Elektrode mehrere Graben-Gateelektroden (200) des MOS-Typs umfaßt, die mindestens zwei Arten von unterschiedlichen Intervallen aufweisen und von einer Hauptfläche des Substrats aus in den vierten Halbleiterbereich (110) verlaufen, und
die Halbleitervorrichtung einen zwischen den Graben-Gateelektroden (200) und zwischen dem vierten und dem fünften Halbleiterbereich (110, 120) angeordneten siebten Halbleiterbereich (151) des zweiten Leitungstyps aufweist, der die Graben-Gateelektroden (200) kontaktiert und eine höhere Ladungsträgerkonzentration hat als der vierte Halbleiterbereich (110). (Figur 10)

## Revendications

1. Dispositif à semi-conducteurs, comportant :
une première région semi-conductrice (100) d'un premier type de conduction contiguë à une surface principale d'un substrat semi-conducteur,
une deuxième région semi-conductrice (112) d'un second type de conduction contiguë à ladite première région semi-conductrice (100) et ayant une concentration de porteurs inférieure à celle de la première région semi-conductrice (100),
une troisième région semi-conductrice (111) du second type de conduction contiguë à ladite deuxième région semi-conductrice (112) et ayant une concentration de porteurs inférieure à celle de la deuxième région semi-conductrice (112),
une quatrième région semi-conductrice (110) du second type de conduction contiguë à ladite troisième région semi-conductrice (111) et ayant une concentration de porteurs inférieure à celle de la troisième région semi-conductrice (111),
une cinquième région semi-conductrice (120) du premier type de conduction s'étendant depuis une surface principale dudit substrat semi-conducteur dans ladite quatrième région semi-conductrice (110),
une sixième région semi-conductrice (130) du second type de conduction s'étendant depuis une surface principale dudit substrat semi-conducteur dans la cinquième région semi-conductrice correspondante (120),
un film diélectrique (300) formé sur une partie exposée de la surface principale de la cinquième région semi-conductrice (120) entre lesdites quatrième et sixième régions semi-conductrices (110, 130),
une première électrode (200) formée sur le film diélectrique correspondant (300),
une deuxième électrode (600) étant en contact avec lesdites cinquième et sixième régions semi-conductrices (120, 130), et
une troisième électrode (500) étant en contact avec ladite première région semi-conductrice (100),
dans lequel la concentration de porteurs maximum de ladite première région semi-conductrice (100) est de 10 à 100 fois la concentration de porteurs maximum de ladite deuxième région semi-conductrice (112),
**caractérisé en ce que** la concentration de porteurs de ladite seconde région semi-conductrice (112) est de 1 x 10¹² cm⁻² à 1 x 10¹³ cm⁻².

2. Dispositif à semi-conducteurs selon la revendication 1, dans lequel ladite cinquième région semi-conductrice (120) s'étend dans ladite quatrième région semi-conductrice (110) depuis une surface principale dudit substrat autre que celle étant contiguë à ladite première région semi-conductrice (100). (Fig. 1)

3. Dispositif à semi-conducteurs selon la revendication 2, dans lequel l'épaisseur de ladite deuxième région semi-conductrice (112) est inférieure à celle de ladite troisième région semi-conductrice (111) et l'épaisseur de ladite troisième région semi-conductrice (111) est inférieure à celle de ladite quatrième région semi-conductrice (110).

4. Dispositif à semi-conducteurs selon la revendication 1,
dans lequel ladite cinquième région semi-conductrice (120) s'étend dans ladite quatrième région semi-conductrice (110) depuis la surface dudit substrat qui est contiguë à ladite première région semi-conductrice (100), et
dans lequel ladite troisième électrode (500) est agencée sur la même surface principale dudit substrat que ladite deuxième électrode (600) et espacée de celle-ci. (Fig. 4)

5. Dispositif à semi-conducteurs selon la revendication 2 ou 4, dans lequel le dispositif à semi-conducteurs a une septième région semi-conductrice (150) du second type de conduction agencée entre lesdites quatrième et cinquième régions semi-conductrices (110, 120), contiguë à ladite cinquième région semi-conductrice (120) et ayant une concentration de porteurs supérieure à celle de ladite quatrième région semi-conductrice (110). (Fig. 6)

6. Dispositif à semi-conducteurs selon la revendication 2 ou la revendication 4, dans lequel l'épaisseur de ladite première région semi-conductrice (100) est de 3 µm ou inférieure.

7. Dispositif à semi-conducteurs selon la revendication 2 ou 4, dans lequel la surface de ladite troisième électrode (500) en contact avec ladite première région semi-conductrice (100) contient de l'aluminium.

8. Dispositif à semi-conducteurs selon la revendication 2, dans lequel :
ladite première électrode inclut une pluralité d'électrodes de grille enterrées de type MOS (200) ayant au moins deux types d'intervalles différents et s'étendant depuis une surface principale dudit substrat dans ladite quatrième région semi-conductrice (110), et
le dispositif à semi-conducteurs a une septième région semi-conductrice (151) du second type de conduction étant entre lesdites des électrodes de grille enterrées (200), positionnée entre lesdites quatrième et cinquième régions semi-conductrices (110, 120), en contact avec lesdites électrodes de grille enterrées (200) et ayant une concentration en porteurs supérieure à celle de ladite quatrième région semi-conductrice (110). (Fig. 10)
